# EUROPÄISCHE PATENTSCHRIFT

(11) **EP 0 786 793 B1**
(45) Veröffentlichungstag und Bekanntmachung des Hinweises auf die Patenterteilung: **13.07.2005**
(21) Anmeldenummer: 96120324.7
(22) Anmeldetag: 18.12.1996
(51) Int. Cl.: H01J 37/32

(54) **Vorrichtung zur Oberflächenbehandlung von Werkstücken**
Workpiece surface treatment device
Dispositif de traitement de surface de pièces de travail

(30) Priorität: 17.01.1996 DE 19601436
(43) Veröffentlichungstag der Anmeldung: 30.07.1997
(73) Patentinhaber: Strämke, Siegfried, Dr., D-52538 Selfkant (DE)
(72) Erfinder: Strämke, Siegfried, Dr., D-52538 Selfkant (DE)
(74) Vertreter: Selting, Günther, Dipl.-Ing.

(56) Entgegenhaltungen:
- WO-A-91/12628
- WO-A-93/04789
- DE-A- 3 910 931
- FR-A- 2 078 067
- US-A- 3 108 900
- US-A- 4 227 897
- US-A- 4 296 637
- US-A- 4 645 981
- US-A- 4 655 800
- PATENT ABSTRACTS OF JAPAN Bd. 014, Nr. 562 (C-0788) 13 Dezember 1990 & JP 02 243 504 A (KOBE STEEL LTD) 27 September 1990
- PATENT ABSTRACTS OF JAPAN Bd. 007, Nr. 211 (M-243) 17 September 1983 & JP 58 106 186 A (HITACHI SEISAKUSHO KK) 24 Juni 1983

## Beschreibung

Die Erfindung betrifft eine Vorrichtung zur Oberflächenbehandlung insbesondere poröser Werkstücke.

Von allen bekannten Oberflächenbehandlungsverfahren finden insbesondere Plasmabehandlungsverfahren, z.B. PVD-Verfahren und CVD-Verfahren sowie insbesondere das Plasmanitrieren und das Plasmaaufkohlen als moderne Härte- und Beschichtungsverfahren in zunehmenden Maße Verwendung.

Um ein Plasmabearbeitungsverfahren mit guten Bearbeitungsergebnissen durchführen zu können, ist es erforderlich, daß der Bearbeitungsprozeß in einer definierten Gasatmosphäre durchgeführt wird. Die Gasatmosphäre ist dabei verdünnt und weist einen Druck im Bereich eines hohen Vakuums auf.

Bekannte Vorrichtungen zur Plasmabehandlung weisen daher einen Vakuumbehälter zur Aufnahme der Werkstücke auf, der mit einer Saugquelle verbunden ist, um in dem Vakuumbehälter einen Unterdruck zu erzeugen.

Grundsätzlich können mit den bekannten Vorrichtungen auch poröse Werkstücke einer Plasmabehandlung unterzogen werden. In den Poren und Kammern poröser Werkstücke können sich jedoch Fremdstoffe, insbesondere flüssige und feste Kohlenwasserstoffe, festsetzen. Verschmutzte Oberflächen und Poren aber setzen Gase in die Vakuumatmosphäre frei und stören damit die eingestellte Atmosphäre. Verschmutzungen, die nicht flüchtig sind, z.B. Abbrandrückstände, haben darüberhinaus den Nachteil, daß sie die Werkstückoberfläche passivieren und damit eine nachfolgende Plasmabehandlung erschweren oder unmöglich machen. Um poröse Werkstücke in einem Vakuumbehälter einer Plasmabehandlung unterziehen zu können, ist es daher zunächst erforderlich, die porösen Werkstücke einer Vorbehandlung zu unterziehen, bei der Fremdstoffe aus den Poren und Kammern der porösen Werkstücke entfernt werden.

Ein bekannter Vorbearbeitungsprozeß umfaßt zunächst das Abbrennen der Kohlenwasserstoffe in einer definierten Gasatmosphäre in einem Abrennofen und danach ein mechanisches Abtragen, z.B. ein Strahlen der Oberfläche.

Anstatt einer Vorbehandlung in einer besonderen Vorrichtung ist es aus DE 42 28 499 C1 bekannt, sowohl Vorbehandlungen als auch ein anschließendes Beschichten des Werkstücks in einem Vakuumbehälter durchzuführen. Zur Vorbehandlung wird das Werkstück mit Hilfe einer Niedervoltbogenentladung beispielsweise gereinigt und aufgeheizt. Anschließend wird das Werkstück mittels einer Vakuumbogenentladung zwischen einem Target und einer anodischen Elektrode beschichtet. Ferner weist die hierzu verwendete Vorrichtung einen Evakuierungsanschluß auf. Da die verdampften Teilchen über den Evakuierungsanschluß, also eine Vakuumpumpe aus dem Vakuumbehälter entfernt werden müssen, kann die Pumpe beschädigt werden. Eine Beschädigung der Pumpe kann insbesondere dann auftreten, wenn eine große Menge störender Fremdstoffe abgesaugt werden muss oder ein hochfeines Vakuum erzeugt werden muss, da eine hierfür ausgelegte Pumpe besonders empfindlich ist.

Aus DE 31 36 515 A1 ist ferner eine Zerstäubungsvorrichtung zur Zerstäubung eines Elements mittels einer Plasmaquelle bekannt. Diese Vorrichtung weist eine Sammelfläche auf, auf welcher das zerstäubte Material gesammelt wird, in dem die Sammelfläche beispielsweise auf Anodenpotential gelegt wird. Um eine solche Sammelfläche in einer Vorrichtung einsetzen zu können, in der Werkstück gereinigt und anschließend beschichtet werden soll, müsste die Sammelfläche möglichst nahe an dem Werkstück angeordnet werden, damit keine Fremdstoffe in die während der Reinigung betriebenen Vakuumpumpe gelangen können. Sobald ein Werkstück jedoch allseitig gereinigt werden muss, kann durch entsprechende Sammelflächen nicht sichergestellt werden, dass keine Fremdstoffe zur Pumpe gelangen und diese beschädigen.

Die Vorreinigung poröser Werkstücke ist für eine nachfolgende Plasmabehandlung von entscheidender Bedeutung. Wegen der aufwendigen Werkstückvorbereitung und der dazu erforderlichen Apparaturen werden poröse Werkstücke aber bisher nur in Ausnahmefällen einer Plasmabearbeitung unterzogen.

Aus US-A-4,655,800 ist eine Vorrichtung zur Plasmabehandlung von Werkstücken mit einem Vakuumbehälter bekannt, bei welchem die aus dem Vakuumbehälter abgesaugten Gase einer Gasfalle zugeleitet werden, welche reaktives Gas abspaltet und in die Atmosphäre entlässt, damit es nicht in die angeschlossene Saugquelle gelangt und diese beschädigt.

In P.A.J., Band 7, Nr. 211 (M-243), 17-09-1983 & JP-106186 A ist ein Kondensatabscheider beschrieben, der mit einer Plasma-Bearbeitungsvorrichtung verbunden ist und flüssigen Wasserstoff enthält. Zur Durchführung der Reinigung des Abscheiders wird der Wasserstoff abgelassen und es wird eine Reinigungsflüssigkeit durch den Abscheider geleitet, welche die abgelagerten Bestandteile fortspült.

Eine Vorrichtung zur Oberbehandlung ist beschrieben in DE-C-2 106 850. Diese Vorrichtung weist einen Vakuumbehälter auf, dessen Behälterwand als Gegenelektrode dient, während das Werkstück die Elektrode bildet. Zwischen Werkstück und Gegenelektrode befindet sich eine Hilfselektrode in Form eines Metallrohres, das an den Enden offen ist. Die Behälterwand ist an Massepotential gelegt und das Werkstück wird an negatives Potential gelegt. Die Hilfselektrode wird entweder potentialfrei geschaltet oder an ein Potential gelegt, das zwischen demjenigen des Werkstücks und der Behälterwand liegt. Vor der Durchführung einer Glimmentladung erfolgt ein Anlaufvorgang, bei dem die Hilfselektrode ohne jede elektrische Verbindung mit dem Behälter gehalten wird. Zwischen dem Werkstück und der Hilfselektrode bildet sich eine Glimmentladung relativ geringer Energie aus. Die rohrförmige Hilfselektrode, die vorzugsweise auf der Innenseite mit einer polierten Oberfläche versehen ist, wird, falls die Entladungsenergie nicht ausreicht, auf ein bestimmtes Spannungspotential gelegt. Nach Abschluss einer ersten Zeitperiode erfolgt die Umschaltung der Hilfselektrode auf das Potential der Gegenelektrode.

Der Erfindung liegt die Aufgabe zugrunde, eine Vorrichtung zur Verfügung zu stellen, die mit einfachen Mitteln die Plasmabearbeitung poröser Werkstücke mit gleichbleibend guter Qualität ermöglicht.

Die Lösung dieser Aufgabe erfolgt erfindungsgemäß mit den Merkmalen des Patentanspruchs 1.

Die Vorrichtung zur Oberflächenbehandlung poröser Werkstücke gemäß der Erfindung zeichnet sich dadurch aus, dass in der Saugleitung zwischen dem Vakuumbehälter und der Saugquelle ein Abscheider angeordnet ist, der aus dem aus dem Vakuumbehälter abgesaugten Gasgemisch Fremdstoffe abscheidet. Der Abscheider ermöglicht es, einen Reinigungsprozess durchzuführen, bei dem große Mengen störender Fremdstoffe abgesaugt werden, ohne dabei die zur Erzeugung eines hochfeinen Vakuums ausgelegte Saugquelle zu beschädigen. Da die von den Werkstücken entfernten Fremdstoffe in dem Abscheider abgeschieden werden, kann der von der Saugquelle gelieferte Gasstrom mit geringem Aufwand aufbereitet und rezirkuliert oder einer geordneten Entsorgung zugeführt werden.

Die erfindungsgemäße Vorrichtung zur Oberflächenbehandlung poröser Werkstücke weist als Hilfselektrode eine einen Werkstück-Aufnahmebereich mindestens teilweise umgebende Elektrodenanordnung in Form eines Gitterkäfigs auf. Diese Elektrodenanordnung, die ein den Werkstückaufnahmebereich einhüllendes Gitter ist, ermöglicht es, wahlweise zwischen der Behälterwandung als Gegenelektrode und der Hilfselektrode oder zwischen der Hilfselektrode und den Werkstücken ein Plasma zu erzeugen. Dadurch kann der Reinigungsprozess seinem Fortschritt entsprechend gesteuert werden.

Die Hilfselektrode erleichtert auch die Ausbildung eines statischen elektrischen Feldes zur Beschleunigung von Gasionen während der Reinigungsphase. Um die in den verschiedenen Phasen der Oberflächenbehandlung erforderlichen elektrischen Felder zu erzeugen, ist eine die Werkstücke und Elektroden versorgende Spannungsquelle wahlweise zwischen einem Felderzeugungsmodus, einem gepulsten Plasmaerzeugungsmodus und einem Hilfsmodus schaltbar.

Es ist möglich, in der erfindungsgemäßen Vorrichtung die porösen Werkstücke in dem Vakuumbehälter nacheinander zunächst einem Reinigungsprozess zum Verdampfen und Absaugen anhaftender Fremdstoffe und danach einem Plasmabehandlungsprozess zu unterziehen, ohne dass die Werkstücke zwischen dem Reinigungsprozess und dem Plasmabehandlungsprozess von einem Reinigungsbehälter in einen speziellen Plasmabehandlungsbehälter überführt werden müssen. Da der Reinigungsprozess und der Plasmabehandlungsprozess in demselben Vakuumbehälter nacheinander durchgeführt werden, wird eine im Reinigungsprozess gereinigte Werkstückoberfläche vor der Plasmabehandlung nicht durch Umwelteinflüsse negativ beeinträchtigt, so dass die Gefahr einer Passivierung und damit eines schlechten Plasmabehandlungsergebnisses reduziert wird.

Darüber hinaus wird der Arbeitsablauf vereinfacht und der erforderliche apparative Aufwand reduziert. Ferner werden Zeit und Energie dadurch eingespart, dass es nicht erforderlich ist, für die Verdampfung erwärmte Werkstücke abzukühlen, und anschließend für den Plasmabehandlungsprozess erneut zu erwärmen. Der beim Absaugen von Fremdstoffen während des Reinigungsprozesses erzeugte Unterdruck kann bei der Erzeugung der Atmosphäre für den Plasmabehandlungsprozess ausgenutzt werden.

Wenn regelmäßig besonders große Fremdstoffmengen anfallen, kann die Saugquelle zwei Saugpumpen aufweisen, von denen die eine unempfindlich gegen Fremdstoffe ist und für den Reinigungsprozess vorgesehen ist und von denen mit der anderen ein starkes Vakuum aufgebaut werden kann.

Besondere Probleme bestehen, wenn die porösen Werkstücke gesinterte Körper sind, die zur Abrichtung auf ein bestimmtes Maß gepresst sind. Solche Sinterkörper weisen üblicherweise große Öl-, Fett- oder Wachsmengen an ihren Oberflächen auf, die während der Herstellung der Sinterkörper die Werkzeuge vor Verschleiß schützen.

Wenn mit der Vorrichtung stark mit Kohlenwasserstoffen, beispielsweise mit Öl, Fett oder Wachs verunreinigte Werkstücke bearbeitet werden, besteht die Gefahr, dass diese Stoffe die Saugquelle beschädigen. Bei einer bevorzugten Ausführungsform der Vorrichtung ist der Abscheider daher vorzugsweise ein Kohlenwasserstoffabscheider mit einem Kondensator, der mit einer Heizvorrichtung zur Reinigung des Kondensators versehen ist. Mit dem Kondensator können auch dampfförmige und gasförmige Kohlenwasserstoffe abgeschieden werden, so dass die Saugquelle wirkungsvoll geschützt wird. Die Heizvorrichtung erlaubt es, den Kondensator zu reinigen, wenn dieser durch Kohlenwasserstoffablagerungen in seiner Wirksamkeit beeinträchtigt wird.

Wenn große Wachsmengen anfallen, besteht auch die Gefahr, dass die Saugleitung von dem Vakuumbehälter zu dem Kondensator durch Wachsablagerungen verstopft. Um die Bildung von Wachsablagerungen zu verhindern, ist die Saugleitung vorzugsweise mit Gefälle vom Vakuumbehälter zum Kondensator ausgebildet und mit einer Heizung oder einer Isolierung versehen, so dass sich Wachs an der Saugleitungswandung nicht niederschlägt.

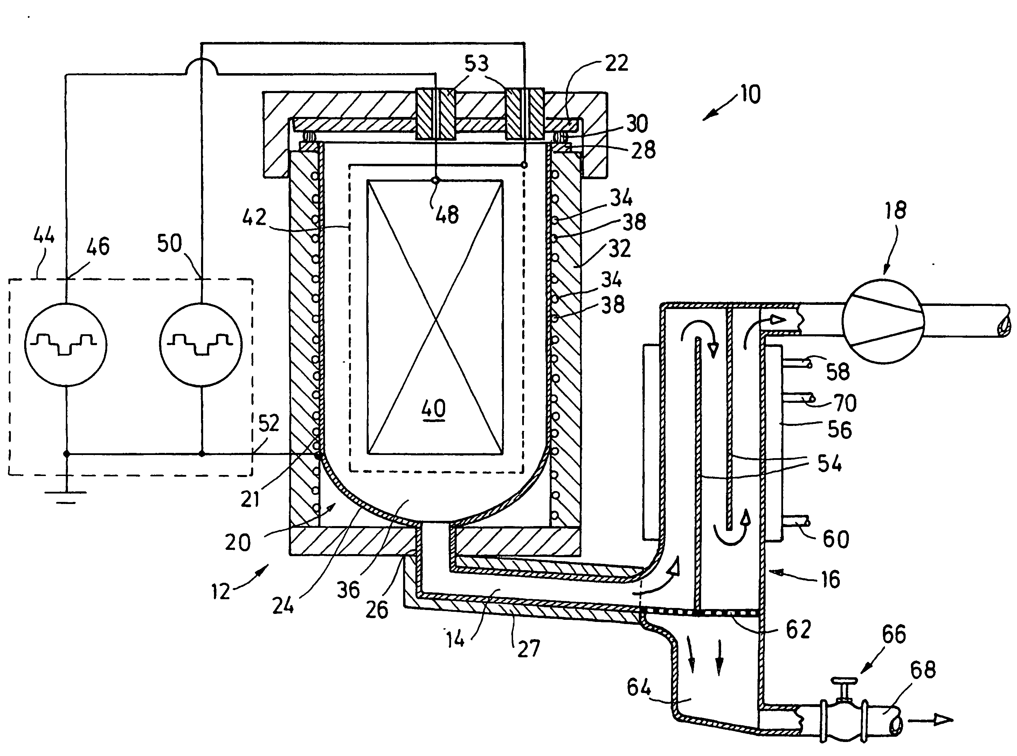

Weitere vorteilhafte Ausgestaltungen und Weiterbildungen der Erfindung ergeben sich aus den Unteransprüchen sowie aus der Beschreibung im Zusammenhang mit der Zeichnung, die eine besonders bevorzugte Ausführungsform der Vorrichtung betrifft.

In der Zeichnung ist eine erfindungsgemäße Vorrichtung zur Oberflächenbehandlung in einem Schnitt gezeigt.

Die Vorrichtung 10 zur Oberflächenbehandlung poröser Werkstücke weist einen Vakuumbehälter 12 auf, der über eine Saugleitung 14 und einen Abscheider 16 an eine Saugquelle 18 angeschlossen ist.

Der Vakuumbehälter 12 besteht aus einem vakuumdichten Kessel 20 mit einer Behälterwand 21. Der Vakuumbehälter 12 ist mit einem abnehmbaren Deckel 22 verschließbar. An seinem unteren stirnseitigen Ende weist der Kessel 20 eine Ablaufwanne 24 auf, an der zentral ein Ablaufstutzen 26 zum Anschluss an die Saugleitung 14 vorgesehen ist. Die Saugleitung weist eine thermische Isolierung 27 auf. Der Kessel 20 weist an seinem oberen Ende einen Lagerring 28 auf, auf den der Deckel 22 unter Zwischenfügung einer Ringdichtung 30 aufgelegt ist.

Der Kessel 20 ist allseitig mit einem thermischen Isoliermantel 32 versehen. Mit einer an der Behälterwand anliegenden und in dem Isoliermantel 32 eingebetteten Heizvorrichtung 34 ist der Innenraum 36 des Vakuumbehälters 12 beheizbar. Eine ebenso in dem Isoliermantel 32 eingebettete Kühlvorrichtung 38 erlaubt ein Abkühlen der Wandung des Vakuumbehälters 12.

Im Innenraum 36 des Vakuumbehälters 12 ist ein Werkstückaufnahmebereich 40 ausgebildet, in welchen Werkstücke chargenweise positionierbar sind. Der Werkstückaufnahmebereich 40 ist von einem Drahtgitterkäfig 42 umgeben, der mit Abstand zu der Behälterwandung 21 und dem Werkstückaufnahmebereich 40 angeordnet ist und als Hilfselektrode geschaltet werden kann.

Um in dem Vakuumbehälter 12 ein elektrisches Feld oder ein Plasma zu erzeugen, ist eine Spannungsquelle 44 vorgesehen, deren erster Ausgang 46 mit einer Anschlußvorrichtung 48 verbunden ist, mit der Werkstücke als Elektrode anschließbar sind. Ein zweiter Ausgang 50 der Spannungsquelle 44 ist mit dem Drahtgitterkäfig 42 und ein dritter Ausgang 52 leitend mit der Behälterwandung 21 verbunden, die je nach Schaltung der Spannungsquelle eine Gegenelektrode bildet. Die Leitungsdurchführungen 53 der Leitungen, die von dem ersten Ausgang 46 und dem zweiten Ausgang 50 zu der Anschlußvorrichtung 48 bzw. dem Drahtgitterkäfig 42 verlaufen, führen durch den Deckel 22 des Vakuumbehälters 12, wobei die Leitungsdurchführungen vorzugsweise selbstreinigende Isolierkörper gemäß DE-PS 39 10 931 aufweisen. Die Spannungsquelle 44 ist vorzugsweise so geschaltet, daß die Wandung 21 des Unterdruckkessels 20 auf Erdpotential liegt.

Die beschriebene Vorrichtung 10 kann in unterschiedliche Betriebsweisen eine Oberflächenbehandlung durchführen. Zunächst wird der Vakuumbehälter 12 beladen und geschlossen.

Dann erfolgt das Reinigen der Werkstücke im Reinigungsprozeß, der dem Plasmabehandlungsprozeß vorgeschaltet ist. Dazu werden in dem Vakuumbehälter 12 vorhandene Werkstücke aufgeheizt. Dadurch verdampfen an den Werkstücken anhaftende Kohlenwasserstoffe und andere Fremdstoffe. Die von den Werkstücken gelösten Fremdstoffe werden aus dem Vakuumbehälter 12 abgesaugt.

Beim Reinigungsprozeß wird durch die Saugquelle 18 ein Gasstrom aus dem Innenraum 36 des Vakuumbehälters 12 abgesaugt. Der Gasstrom wird durch den Abscheider 16 geführt, in welchem mehrere Umlenkbleche 54 angeordnet sind, durch die der Gasstrom mehrfach umgelenkt wird. Um den Abscheider 16 als Kondensator zu betreiben, wird zur Abkühlung des Abscheiders 16 durch eine Kühlmittelzufuhrleitung 58 einer Kühlvorrichtung 56 ein Kühlmittel zugeführt, das über eine Kühlmittelabfuhrleitung 60 abgeführt wird. An den Wänden des Abscheiders 16 und an den Umlenkblechen 54 schlagen sich Kohlenwasserstoffe nieder, die durch eine Lochplatte 62 in einen Kondensatablauf 64 ablaufen. Um Fremdstoffe, die sich in der Saugleitung 14 niederschlagen, abzuleiten, weist diese zum Kondensatablauf 64 hin ein Gefälle auf. Wenn sich in dem Kondensatablauf 64 eine bestimmte Menge Kondensat gesammelt hat, kann ein Absperrschieber 66 geöffnet werden, so daß das Kondensat über eine Kondensatleitung 68 abgeleitet werden kann.

Durch Erwärmung der Werkstücke auf eine Temperatur unterhalb der Zersetzungstemperatur von Kohlenwasserstoffrückständen wird der Reinigungsprozeß beschleunigt, ohne daß sich Zersetzungsrückstände bilden würden, die den Plasmabehandlungsprozeß negativ beeinträchtigen würden.

Werkstücke, die einem solchen Reinigungsprozeß als Basisbehandlung unterzogen worden sind, können anschließend unter Beibehaltung bzw. Verstärkung des Vakuums unmittelbar einer Plasmabehandlung unterzogen werden.

Um das Absaugen der von den Werkstücken verdampften Kohlenwasserstoffspuren zu erleichtern, kann zwischen einer Hilfselektrode und einer Gegenelektrode ein Plasma gezündet werden, in welchem die Kohlenwasserstoffe umgewandelt werden. Wenn dabei die Behälterwandung 21 als Gegenelektrode verwendet wird, reinigt ein solches Plasma auch die Behälterwandung 21.

Wenn besonders reine Oberflächen erforderlich sind, kann im Anschluß an die Basisbehandlung eine Zwischenreinigungsphase eingeschoben werden, in welcher Kohlenwasserstoffspuren durch in einem elektrischen Feld beschleunigte Gasionen von den Werkstücken gelöst werden. Das elektrische Feld kann dabei durch Anlegen einer Spannung zwischen Werkstück und einer Gegenelektrode, beispielsweise der Behälterwand des Vakuumbehälters oder einer Hilfselektrode, erzeugt werden. Durch die Beschleunigung der Gasionen auf das poröse Werkstück hin wird eine schonende Reinigung der Poren und Hohlräume des Werkstücks ohne die Gefahr von verkokenden Ablagerungen erreicht.

Die in der Zwischenreinigungsphase verwendeten Gasionen können in einem Plasma erzeugt werden, das zwischen zwei von den Werkstücken entfernten Elektroden, beispielsweise dem Drahtgitterkäfig 42 und der Behälterwand 21 erzeugt wird. Das elektrische Feld, das die Gasionen zu den Werkstücken trägt, ist dazu unabhängig von der Plasmaerzeugung und kann schwach ausgebildet sein. Dadurch ist die Aufheizung der Werkstücke gering und die Temperatur der Werkstücke liegt insbesondere unter einer Temperatur, bei der Kohlenwasserstoffe verkoken.

Der Reinigungsprozeß kann auch mit einer Nachreinigungsphase durchgeführt werden, in der die Werkstücke in einem sie einhüllenden Plasma gereinigt werden. Bei dieser Plasmareinigung, bei der ebenfalls abgesaugt wird, sind die Werkstücke mindestens zeitweise als Kathode geschaltet. Das zur Plasmareinigung erzeugte Plasma ist vorzugsweise gepulst, wodurch eine thermische Überlastung der Werkstücke verhindert wird.

Um Verkrustungen zu verhindern, die sich aus Kohlenwasserstoffrückständen bilden können, ist das Tastverhältnis zwischen Puls-Einschaltzeit und Puls-Pausenzeit des Plasmas dem Prozeßfortschritt angepaßt. Vorzugsweise wird die Puls-Einschaltzeit dabei im Verhältnis zur Puls-Pausenzeit in dem Maße verlängert, in dem die Reinigung fortschreitet, da Kohlenwasserstoffspuren von wenigen Nanometern Dicke keine hartnäckigen Verkrustungen bilden. Der Reinigungsfortschritt kann insbesondere dadurch bestimmt werden, daß der Abfall des Vakuums in dem Vakuumbehälter 12 durch die Gasbildung aus den Kohlenwasserstoffspuren überwacht wird. Das Tastverhältnis zwischen Puls-Einschaltzeit und Puls-Pausenzeit wird dann vorzugsweise in Abhängigkeit von diesen Überwachungsergebnissen gesteuert. Eine in dem Vakuumbehälter 12 permanent aufrechterhaltene Basisentladung ermöglicht bei einem Reinigungsprozeß die Ionenbildung und erleichtert unter Verwendung eines gepulsten Plasmas in der Nachreinigungsphase das wiederholte Zünden des Plasmas.

In der Reinigungsphase erweist sich der Drahtgitterkäfig 42 als besonders vorteilhaft, da er eine getrennte Steuerung des Feldes zur Erzeugung des Plasmas und des Feldes zum Ionentransport zu den Werkstücken erlaubt. Die Spannung zwischen dem Drahtgitterkäfig 42 und der Behälterwand 21 ist vorzugsweise hoch und gepulst, wogegen die Spannung zwischen Drahtgitterkäfig 42 und den Werkstücken klein und konstant ist. Dadurch kann eine Feststoffbildung bei der Beseitigung von Kohlenwasserstoffrückständen verhindert werden. Wenn Kohlenwasserstoffrückstände bis zu einer Dicke im Nanometerbereich herab beseitigt worden sind, kann auch zwischen dem Drahtgitterkäfig 42 und den Werkstücken ein Plasma gezündet werden, das die Werkstücke reinigt.

Zur Reinigung des Abscheiders 16 kann eine über eine Anschlußleitung 70 von einer Stromquelle versorgte Heizvorrichtung eingeschaltet werden. An den Wänden und den Umlenkblechen 54 anhaftende und dort erstarrte Kohlenwasserstoffe werden dadurch dünnflüssig und tropfen in den Kondensatablauf 64.

Um bei einem Plasmabearbeitungsverfahren, das mit der Vorrichtung 10 im Anschluß an die Reinigungsphase ausgeführt wird, eine gewünschte Atmosphäre einstellen zu können, beispielsweise eine Stickstoffatmosphäre zum Nitrieren, ist an dem Vakuumbehälter 12 eine Gaseinlaßvorrichtung vorhanden, über die Reaktions- und/oder Inertgase in den Innenraum 36 des Vakuumbehälters 12 geleitet werden können. Die gezeigte Vorrichtung 10 eignet sich sowohl für PVD- als auch für CVD-Verfahren und insbesondere zum Plasmanitrieren und Plasmaaufkohlen.

Um den Plasmabehandlungsprozeß gezielt steuern zu können, ist ein die Temperatur der Werkstücke ermittelndes Meßelement vorgesehen, das auf dem Werkstückpotential liegt. Da auch die Temperatur des Kessels 20 überwacht wird und ggf. mit der Heizvorrichtung 34 oder der Kühlvorrichtung 38 beeinflußt, können in dem Vakuumbehälter 12 stets optimale Plasmabehandlungsbedingungen eingehalten werden. Während der Plasmabehandlung dient die Kühlvorrichtung 38 dazu, ein Überhitzen des Kessels 20 zu verhindern.

## Patentansprüche

1. Vorrichtung zur Oberflächenbehandlung poröser Werkstücke, mit einem Vakuumbehälter (12) zur Aufnahme der Werkstücke, einer in dem Vakuumbehälter (12) angeordneten Anschlussvorrichtung (48), mit der die Werkstücke als Elektroden an eine Spannungsquelle (44) anschließbar sind, wobei die Behälterwandung eine Gegenelektrode (21) bildet, einer Saugquelle (18), die über eine Saugleitung (14) mit dem Vakuumbehälter (12) verbunden ist, und einem in der Saugleitung (14) zwischen dem Vakuumbehälter (12) und der Saugquelle (18) angeordneten Abscheider (16), der aus dem aus dem Vakuumbehälter (12) abgesaugten Gasgemisch Fremdstoffe abscheidet,
**dadurch gekennzeichnet,**
**dass** in dem Vakuumbehälter (12) eine einen Werkstückaufnahmebereich mindestens teilweise umgebende Hilfselektrode (42) in Form eines Gitterkäfigs angeordnet ist, wobei das zwischen Hilfselektrode (42) und Gegenelektrode (21) erzeugte elektrische Feld zur Erzeugung eines Plasmas und das zwischen Werkstück (40) und Hilfselektrode (42) erzeugte elektrische Feld zum Transport von Jonen zu dem Werkstück getrennt steuerbar sind.

2. Vorrichtung nach Anspruch 1, **dadurch gekennzeichnet, dass** zwischen der Gegenelektrode (21) und der Hilfselektrode (42) ein Plasma zur Umwandlung der von dem Werkstück (40) entweichenden Kohlenwasserstoffe erzeugbar ist, wobei das elektrische Feld zwischen Hilfselektrode (42) und Werkstück (40) unabhängig ist von der Plasmaerzeugung zwischen Gegenelektrode (21) und Hilfselektrode (42).

3. Vorrichtung nach Anspruch 1 oder 2, **dadurch gekennzeichnet, dass** die Spannungsquelle (44) wahlweise zwischen einem Felderzeugungsmodus, in welchem zwischen den Werkstücken und der Gegenelektrode (21) ein statisches Feld anliegt, und einem gepulsten Plasmaerzeugungsmodus schaltbar ist.

4. Vorrichtung nach Anspruch 3, **dadurch gekennzeichnet, dass** im Plasmaerzeugungsmodus das Tastverhältnis zwischen Puls-Einschaltzeit und Puls-Pausenzeit des Plasmas dem Prozessfortschritt anpassbar ist.

5. Vorrichtung nach einem der Ansprüche 1-4, **dadurch gekennzeichnet, dass** die Spannungsquelle (44) wahlweise in einen Hilfsmodus schaltbar ist, in welchem während der Erzeugung eines Plasmas zwischen Werkstück (40) und Hilfselektrode (42) ein weiteres Plasma zwischen Gegenelektrode (21) und Hilfselektrode (42) erzeugt wird.

## Claims

1. An apparatus for the surface treatment of porous workpieces, comprising a vacuum container (12) for receiving the workpieces, a connection means (48) arranged in the vacuum container (12) and adapted to connect the workpieces as electrodes to a voltage source (44), the container wall forming a counterelectrode (21), further comprising a vacuum source (18) connected to the vacuum container (12) via a suction pipe (14), and comprising a separator (16) arranged in the course of the suction pipe (14) between the vacuum container (12) and the vacuum source (18) for separating foreign substances from the gas mixture sucked from the vacuum container (12),
**characterized in**
**that** the vacuum container (12) has arranged therein an auxiliary electrode (42), formed as a lattice and at least partially surrounding a workpiece receiving space, wherein the electric field generated between the auxiliary electrode (42) and the counterelectrode (21) for generating a plasma, and the electric field generated between the workpiece (40) and the auxiliary electrode (42) are separately controllable for transport of ions to the workpiece.

2. The apparatus according to claim 1, **characterized in that**, between the counterelectrode (21) and the auxiliary electrode (42), a plasma is generable for conversion of hydrocarbons escaping from the workpiece (40), the electric field between the auxiliary electrode (42) and the workpiece (40) being independent of the plasma generation between the counterelectrode (21) and the auxiliary electrode (42).

3. The apparatus according to claim 1 or 2, **characterized in that** the voltage source (44) can be selectively switched between a field generation mode wherein a static field is applied between the workpieces and the counterelectrode (21), and a pulsed plasma generation mode.

4. The apparatus according to claim 3, **characterized in that**, in the plasma generation mode, the duty ratio between the switch-on time and the switch-off time of the plasma pulses can be adapted to the progress of the treatment process.

5. The apparatus according to any one of claims 1-4, **characterized in that** the voltage source (44) can be selectively switched into an auxiliary mode wherein, while a plasma is being generated between the workpiece (40) and the auxiliary electrode (42), a further plasma is generated between the counterelectrode (21) and the auxiliary electrode (42).

## Revendications

1. Dispositif de traitement de surface de pièces de travail poreuses, comprenant un récipient à vide (12) pour recevoir les pièces de travail, un dispositif de branchement (48) disposé dans le récipient à vide (12) permettant de brancher les pièces de travail comme électrodes à une source de tension (44), la paroi de récipient formant une contre-électrode (21), une source d'aspiration (18) qui est reliée par une conduite d'aspiration (14) au récipient à vide (12), et un séparateur (16) qui est disposé dans la conduite d'aspiration (14) entre le récipient à vide (12) et la source d'aspiration (18) et qui sépare des matières étrangères du mélange de gaz aspiré du récipient à vide (12),
**caractérisé en ce qu'**une électrode auxiliaire (42) en forme de cage en grille entourant au moins partiellement une zone de réception de pièce de travail est disposée dans le récipient à vide (12), le champ électrique généré entre l'électrode auxiliaire (42) et la contre-électrode (21) pour générer un plasma et le champ électrique généré entre la pièce de travail (40) et l'électrode auxiliaire (42) pour le transport d'ions vers la pièce de travail pouvant être commandés séparément.

2. Dispositif selon la revendication 1,
**caractérisé en ce qu'**entre la contre-électrode (21) et l'électrode auxiliaire (42) un plasma peut être généré pour transformer les hydrocarbures s'échappant de la pièce de travail (40), le champ électrique entre l'électrode auxiliaire (42) et la pièce de travail (40) étant indépendant de la génération de plasma entre la contre-électrode (21) et l'électrode auxiliaire (42).

3. Dispositif selon la revendication 1 ou 2,
**caractérisé en ce que** la source de tension (44) peut être commutée au choix entre un mode de génération de champ, dans lequel un champ statique est présent entre les pièces de travail et la contre-électrode, et un mode de génération de plasma pulsé.

4. Dispositif selon la revendication 3,
**caractérisé en ce que** dans le mode de génération de plasma le taux d'impulsions entre la durée du fonctionnement pulsé et le temps de pause de pulsation du plasma est adapté à la progression du processus.

5. Dispositif selon l'une quelconque des revendications 1 à 4,
**caractérisé en ce que** la source de tension (44) peut être commutée au choix dans un mode auxiliaire dans lequel pendant la génération d'un plasma entre la pièce de travail (40) et l'électrode auxilaire (42) un autre plasma est généré entre la contre-électrode (21) et l'électrode auxiliaire (42).
